# EUROPÄISCHE PATENTSCHRIFT

(11) **EP 3 081 056 B1**
(45) Veröffentlichungstag und Bekanntmachung des Hinweises auf die Patenterteilung: **03.03.2021**
(21) Anmeldenummer: 14825088.9
(22) Anmeldetag: 12.12.2014
(51) Int. Cl.: H05K 1/18, H05K 3/46, H05K 1/02

(54) **VERFAHREN ZUM EINBETTEN EINER KOMPONENTE IN EINE LEITERPLATTE**
METHOD FOR EMBEDDING A COMPONENT IN A PRINTED CIRCUIT BOARD
PROCÉDÉ D'INTÉGRATION D'UN COMPOSANT DANS UNE CARTE À CIRCUIT IMPRIMÉ

(30) Priorität: 12.12.2013 AT 508212013
(43) Veröffentlichungstag der Anmeldung: 19.10.2016
(60) Teilanmeldung: 20214312.9
(73) Patentinhaber: AT & S Austria Technologie & Systemtechnik Aktiengesellschaft, 8700 Leoben (AT)
(72) Erfinder: SCHWARZ, Timo, 8770 Sankt Michael in Obersteiermark (AT); ZLUC, Andreas, 8700 Leoben (AT); LANGER, Gregor, 9061 Wölfnitz (AT); STAHR, Johannes, 8605 St. Lorenzen (AT)
(74) Vertreter: Patentanwaltskanzlei Matschnig & Forsthuber OG
(86) Internationale Anmeldenummer: PCT/AT2014/050300
(87) Internationale Veröffentlichungsnummer: WO 2015/085342

(56) Entgegenhaltungen:
- JP-A- 2005 333 109
- JP-A- 2012 151 359
- US-A1- 2009 277 673

## Beschreibung

Die vorliegende Erfindung betrifft ein Verfahren zum Einbetten einer Komponente in eine Leiterplatte bzw. ein Leiterplatten-Zwischenprodukt, wobei die Leiterplatte bzw. das Leiterplatten-Zwischenprodukt zumindest eine isolierende Schicht aus einem Prepreg-Material aufweist und die Komponente durch das Harz des Prepreg-Materials festgelegt wird.

Leiterplatten dienen der Festlegung und elektrischen Verbindung von elektronischen Komponenten und deren Anbindung als Modul in elektronischen Geräten. In der Regel bestehen Leiterplatten aus einer Mehrzahl von sich abwechselnden Schichten aus isolierendem Material und leitendem Material, wobei die Schichten aus elektrisch leitendem Material, beispielsweise Kupfer, zu Leiterzügen strukturiert sind, die mit den Kontaktpads der elektronischen Komponenten in Verbindung stehen und diese entsprechend entflechten. Neben der Festlegung und Verbindung der elektronischen Komponenten miteinander können Leiterplatten aufgrund ihrer relativ hohen mechanischen Stabilität zusätzlich eine statische Funktion in einem elektronischen Gerät übernehmen.

Im Sinne der ständig voranschreitenden Miniaturisierung elektronischer Geräte, wie beispielsweise Mobiltelefone, Tabletcomputer und Ähnliches, werden die immer kleiner werdenden elektronischen Komponenten nicht nur auf der Oberfläche von Leiterplatten montiert und verlötet, sondern zunehmend in das Innere, den Querschnitt der Leiterplatten integriert. Ein herkömmliches Verfahren zum Einbetten von elektronischen Komponenten in Leiterplatten sieht hierbei die Herstellung von Freistellungen bzw. Löchern in der Größe und Form der einzubettenden Komponente in der Leiterplatte vor, sodass in einem darauffolgenden Schritt die Komponenten in die jeweiligen Löcher eingesetzt und dort verklebt werden können. Nachteilig beim Verkleben der Komponenten in der Leiterplatte ist jedoch, dass der Klebstoff zwangsläufig ein anderes Material als das Material der isolierenden Schicht in der Leiterplatte ist. Während die isolierenden Schichten in der Leiterplatte aus Prepreg-Materialien, wie beispielsweise FR4, also aus Harzsystemen bestehen, sind die Klebstoffe zum Einsetzen der Komponenten zumeist Lösungsmittel-basiert. Beim Verkleben der Komponenten ergeben sich somit zwangsläufig Inhomogenitäten, wobei sich aufgrund der relativ starken Erhitzung der Komponenten in der Leiterplatte im Betrieb aufgrund unterschiedlicher Wärmeausdehnungskoeffizienten der verwendeten Materialien mit der Zeit Risse bilden, was sich negativ auf die Langlebigkeit der Leiterplatte und somit der entsprechenden elektronischen Geräte auswirkt. In der WO 2012/100274 A1 wurde daher ein Verfahren angegeben, bei welchem die Festlegung der Komponenten in der Leiterplatte nicht mit Klebstoff erfolgt, sondern mit dem Harz der Isolierschichten der Leiterplatte bewerkstelligt wird. Bei der Herstellung von Leiterplatten werden die Isolierschichten, die aus einem Prepreg-Material bestehen, durch Laminieren und Verpressen bei erhöhter Temperatur mit den leitenden Schichten verbunden. Vor dem Laminieren und Verpressen bei erhöhter Temperatur befindet sich das Harz der Prepreg-Materialien in einem nicht-ausgehärteten Zustand, welcher als B-Stage bezeichnet wird. B-Stage-Prepreg wird auf Rollen gekühlt gelagert, um ein frühzeitiges Aushärten des Harzes zu verhindern. Das Verfahren gemäß WO 2012/100274 A1 sieht nun vor, dass in einem Verbund, der aushärtbares Prepreg-Material, d.h. Prepreg-Material im B-Stage enthält, Freistellungen für die Komponenten hergestellt werden, die Komponenten in die Freistellungen bestückt und die Freistellungen bzw. Öffnungen mit den Komponenten mit weiteren Prepreg-Lagen im B-Stage und gegebenenfalls weiteren Kontaktschichten bzw. elektrisch leitenden Schichten überdeckt werden. Hierauf erfolgt das Verpressen dieses Verbunds zur fertigen Leiterplatte, bei der das Prepreg-Material ausgehärtet vorliegt, welcher ausgehärtete Zustand in der Fachwelt als C-Stage bezeichnet wird.

Nachteilig bei diesem Verfahren ist der Umstand, dass zwangsläufig ein Überdecken der Freistellungen mit den Komponenten mit weiteren Lagen erforderlich ist, sodass die Leiterplatten, die nach dem Verfahren gemäß WO 2012/100274 A1 hergestellt wurden, relativ dick waren, was dem Gedanken der Miniaturisierung zuwiderläuft.

Weiters sind aus dem Stand der Technik beispielsweise aus den Dokumenten US 2009/277673 A1, JP 2005 333109 A, JP 2012 151359 A, JP 2011 138873 A sowie US 2012/048605 A1 bereits unterschiedliche Verfahren zum Einbetten von Komponenten in Leiterplatten bekannt geworden Keines dieser Dokumente offenbart das Herstellen einer Freistellung in einem Verbund wobei der Verbund aus einer Mehrzahl von Lagen aus einem aushärtbaren Prepreg-Material und beidseitig außenliegenden Kupferschichten besteht.

Der Erfindung liegt daher die Aufgabe zugrunde, ein Verfahren der eingangs genannten Art dahingehend zu verbessern, dass die Freistellungen und Komponenten überdeckende Prepreg-Schichten vermieden werden können, sodass möglichst dünne Leiterplatten realisierbar sind.

Zur Lösung dieses Problems wird ein Verfahren nach Anspruch 1 vorgeschlagen.

Es wird somit beim erfindungsgemäßen Verfahren ein Verbund aller Schichten der Leiterplatte bzw. des Leiterplatten-Zwischenprodukts bereitgestellt, wobei dieser Verbund Prepreg-Material im B-Stage, d.h. noch aushärtbares Prepreg-Material im Gegensatz zu bereits ausgehärtetem Prepreg-Material enthält. Nach dem Herstellen der Freistellung für die Komponente wird zumindest der Bereich der Freistellung gemäß Schritt c) mit einer ersten temporären Trägerschicht abgedeckt, sodass die einzubettende Komponente auf die erste ersten temporäre Trägerschicht bestückt werden kann. Nun erfolgt das Abdecken des Bereichs der Freistellung mit der darin positionierten Komponente auf der zweiten Seite des Verbundes mit einer zweiten temporären Trägerschicht. Hier kann eine wie auch immer geartete Trennfolie verwendet werden, die lediglich nach dem Aushärten des Prepreg-Materials zum C-Stage abnehmbar sein muss. Das Aushärten des Prepreg-Materials erfolgt in Schritt f) und erfolgt nach Methoden, die im Stand der Technik bestens bekannt sind. In aller Regel wird der Verbund der Schichten der Leiterplatte bzw. des Leiterplatten-Zwischenprodukts mit der bestückten Komponente und den beiden temporären Trägerschichten mit mechanischen Druck beaufschlagt und gleichzeitig erhitzt, sodass eine Quervernetzung des Harzes des Prepreg-Materials der isolierenden Schicht bzw. der isolierenden Schichten erfolgt. Beim Verpressen gemäß Schritt f) fließt das Harz des Prepreg-Materials um die Komponente herum, erfährt an den temporären Trägerschichten eine räumliche Begrenzung und härtet somit auch im Bereich der Komponenten aus, sodass sich eine kontinuierliche Harzphase durch die Prepreg-Schichten, die die isolierenden Schichten der Leiterplatte bzw. des Leiterplatten-Zwischenprodukts bilden, ergibt. Auf diese Weise treten im Betrieb der Leiterplatte, wenn sich die Komponenten erhitzen, nur geringe Spannungen auf, die ohne das Vorhandensein einer Grenzschicht, wie sie beim Verkleben zwischen Klebstoff und Harz auftritt, direkt in die umgebenden Bereiche abgeführt werden können. Da der Bereich der eingebetteten Komponente nicht von zusätzlichen Prepreg-Lagen überdeckt werden musste, um ein Verpressen zu ermöglichen, wird nach dem Entfernen der temporären Trägerschichten gemäß Schritt g) ein überaus dünnes Produkt erhalten, das den heutigen Anforderungen der Miniaturisierung in hervorragender Weise entspricht.

Das erfindungsgemäße Verfahren ist in Bezug auf eine Komponente, die eingebettet wird, definiert. Es ist jedoch für den Fachmann klar, dass in der industriellen Produktion auch eine Vielzahl von Komponenten in ein und demselben Verbund eingebettet werden können, wobei jedoch die Erfindung so zu verstehen ist, dass jeweils nur eine Komponente in jeweils eine Freistellung eingesetzt wird. In der vorliegenden Beschreibung kann daher von der Komponente in der Einzahl oder von einer Mehrzahl von Komponenten die Rede sein, was jedoch nichts am Sinn und am Wesen der vorliegenden Erfindung ändert.

Der Verbund der Schichten der Leiterplatte bzw. des Leiterplatten-Zwischenprodukts besteht aus einer Mehrzahl von Lagen aus einem aushärtbaren Prepreg-Material. Bei Verwendung eines solchen Verbunds in Schritt a) des erfindungsgemäßen Verfahrens resultiert eine besonders homogene Leiterplatte bzw. ein besonders homogenes Leiterplatten-Zwischenprodukt, da sich zwischen den Lagen aus einem Prepreg-Material keine leitenden Schichten befinden und das Harz des Prepreg-Materials daher vor dem Aushärten ungehindert fließen und folglich die einzubettende Komponente bzw. die einzubettenden Komponenten umfließen kann. Nach dem Verpressen und nach dem Entfernen der temporären Trägerschichten muss bei dieser bevorzugten Ausführungsform der vorliegenden Erfindung in der Regel die Verdrahtung bzw. die Entflechtung der eingebetteten Komponente bzw. Komponenten in einem darauffolgenden Bearbeitungsschritt erfolgen, in dem an den Außenseiten Leiterzüge nach bekannten Verfahren ausgebildet werden.

Um die Ausbildung von Leiterzügen zu erleichtern, ist erfindungsgemäß vorgesehen, dass der Verbund der Schichten der Leiterplatte bzw. des Leiterplatten-Zwischenprodukts aus einer Mehrzahl von Lagen aus einem aushärtbaren Prepreg-Material und beidseitig außenliegenden Kupferschichten besteht. Somit stehen nach dem Verpressen und nach dem Entfernen der temporären Trägerschichten beidseitig Kupferschichten an der Außenseite der Leiterplatte bzw. des Leiterplatten-Zwischenprodukts zur Verfügung, aus denen sich beispielsweise durch photolithographische Verfahren geeignete Leiterzüge ausbilden lassen.

Wenn die Leiterplatte bzw. das Leiterplatten-Zwischenprodukt, das mit dem erfindungsgemäßen Verfahren hergestellt werden soll, besondere Anforderungen hinsichtlich der mechanischen Stabilität erfüllen sollen, kann als Ausführungsbeispiel der Verbund der Schichten der Leiterplatte bzw. des Leiterplatten-Zwischenprodukts eine Mehrzahl von Lagen aus einem aushärtbaren Prepreg-Material und einem zentral gelegenen Core sowie beidseitig außenliegenden Kupferschichten umfassen. Unter einem Core wird in der Fachwelt eine Schicht eines ausgehärteten Prepreg-Materials, beispielsweise FR4, mit beidseitig auflaminierten Kupferlagen verstanden. Solche Cores können als Standardbauelement industriell bezogen werden und bieten beim erfindungsgemäßen Verfahren eine gewisse Stabilität bereits vor dem Verpressen des aushärtbaren Prepreg-Materials im Verbund der Schichten der Leiterplatte bzw. des Leiterplatten-Zwischenprodukts, was in einer besseren Handhabbarkeit bei der Verarbeitung und zu einer erhöhten Festigkeit des fertigen Produkts führt. Gegebenenfalls kann das zentral gelegene Core zur Ausbildung von Leiterzügen entsprechend strukturiert sein.

Das erfindungsgemäße Verfahren ermöglicht die Herstellung von Leiterplatten bzw. Leiterplatten-Zwischenprodukten mit eingebetteten Komponenten von besonders geringer Dicke. Gemäß einer bevorzugten Ausführungsform der vorliegenden Erfindung ist das erfindungsgemäße Verfahren daher dahingehend weitergebildet, dass der Verbund der Schichten der Leiterplatte bzw. des Leiterplatten-Zwischenprodukts im Wesentlichen die Dicke der einzubettenden Komponenten aufweist. Eine zu geringe Dicke würde dazu führen, dass die Komponenten über den Querschnitt der Leiterplatte ragen und folglich nicht vollständig vom Harz des Prepreg-Materials umschlossen werden könnten. Eine Dicke des Verbundes der Schichten der Leiterplatte bzw. des Leiterplatten-Zwischenprodukts, die wesentlich über die Dicke der Komponenten hinausgeht, ist jedoch ebenfalls nicht notwendig, um eine ausreichende Einbettung in das Harz des Prepreg-Materials zu gewährleisten.

Wie bereits weiter oben erwähnt, kann das erfindungsgemäße Verfahren auf eine Mehrzahl von Komponenten angewendet werden, sodass eine Mehrzahl von Komponenten in die Leiterplatte eingebettet wird. Wesentlich hierbei ist jedoch, dass das Verfahren, wie es im Hauptanspruch definiert ist, für jede einzelne Komponente ausgeführt wird, sodass jeweils eine Freistellung für jeweils eine einzubettende Komponente hergestellt wird.

Gemäß einer bevorzugten Ausführungsform der vorliegenden Erfindung ist es vorgesehen, dass Komponenten unterschiedlicher Dicke in die jeweiligen Freistellungen bestückt werden und die zweite temporäre Trägerschicht mit einer nicht haftenden Oberfläche zum Verbund der Schichten der Leiterplatte bzw. des Leiterplatten-Zwischenprodukts ausgerichtet wird. In diesem Fall wird die Dicke des Verbundes der Schichten der Leiterplatte bzw. des Leiterplatten-Zwischenprodukts nach der dicksten Komponente bzw. nach den dicksten Komponenten gewählt, sodass dünnere Komponenten den Querschnitt des Verbundes nicht vollständig durchsetzen. Aus diesem Grund muss die zweite temporäre Trägerschicht mit einer nicht haftenden Oberfläche zum Verbund der Schichten der Leiterplatte bzw. des Leiterplatten-Zwischenprodukts ausgerichtet werden, um zu verhindern, dass die Komponente beim Verpressen von einer Kleberschicht auf der zweiten temporären Trägerschicht von ersten temporären Trägerschicht abgehoben wird.

Bevorzugt ist die erste Seite des Verbundes eine Kontaktseite der Leiterplatte bzw. des Leiterplatten-Zwischenprodukts und die einzubettende Komponente wird face-up zu dieser Kontaktseite in der Freistellung befestigt.

Gemäß einer bevorzugten Weiterbildung der vorliegenden Erfindung ist sowohl die erste Seite als auch die zweite Seite des Verbundes eine Kontaktseite der Leiterplatte. In diesem Fall können beide Seiten der Leiterplatte Leiterzüge aufweisen, wodurch eine hochintegrierte und daher platzsparende Leiterplatte erhalten wird.

Von besonderem Vorteil ist dies, wenn eine Komponente mit Kontakten auf zwei gegenüberliegenden Seiten der Komponente eingebettet wird, wie dies Gegenstand einer bevorzugten Ausführungsform der vorliegenden Erfindung ist. Diese Konfiguration gestattet einen vertikalen Stromfluss, d.h. einen Stromfluss durch den Querschnitt der Leiterplatte, wobei die elektronische Komponente als Strombrücke dient.

Bevorzugt ist die Komponente aus der Gruppe bestehend aus einem integrierten Schaltkreis, einer LED, einem Kühlkörper, einer Batterie und einer Leiterplatte, insbesondere einer mehrlagigen Leiterplatte ausgewählt. Insbesondere kann die genannte Komponente jedes aktive oder passive elektronische Bauteil sein, In diesem Zusammenhang kann die elektronische Komponente auch eine voll oder teilweise bestückte Leiterplatte (Modul) oder eine MEMS- oder MOEMS-Struktur sein. Die Komponente kann jedoch auch eine nicht-elektronische Komponente, beispielsweise ein Kühlelement sein, welches insbesondere aus einem metallischen Material besteht. Es ist für den Fachmann offensichtlich, dass mit dem erfindungsgemäßen Verfahren jede Art von elektronischer Komponente eingebettet werden kann, sodass diese Aufzählung nicht als erschöpfend angesehen werden sollte.

Gemäß einer besonders bevorzugten Ausführungsform der vorliegenden Erfindung ist die Komponente ein IMS-Bauteil. Die Abkürzung IMS steht für "insulated metal substrate" und bezeichnet ein Bauteil, bei dem eine dünne Isolatorschicht, beispielsweise auf Epoxyharz-Basis, zwischen einer dicken, metallischen Basisschicht, beispielsweise aus Aluminium oder Kupfer, und einer relativ dünnen leitenden Schicht, beispielsweise aus Aluminium oder Kupfer, angeordnet ist. IMS-Bauteile dienen zur Ankontaktierung und gleichzeitigen Kühlung von Leistungskomponenten, da einerseits die leitende Schicht zu Kontaktstellen und Leiterzügen strukturiert werden kann und andererseits durch die Isolatorschicht gegen die Basisschicht elektrisch isoliert ist, wobei die Isolatorschicht einen guten Wärmedurchgang zur Basisschicht gewährleistet, wo die von der Leistungskomponente anfallende Wärme dissipiert werden kann.

Bevorzugt ist die erste temporäre Trägerschicht in Form eines Klebebandes ausgebildet. Durch die Haftwirkung des Klebebandes erfolgt eine Positionierung bzw. temporäre Befestigung der Komponente, wobei allerdings die zweite temporäre Trägerschicht nicht zwingend ein Klebeband sein muss.

Die Erfindung wird nachfolgend anhand eines in der Zeichnung schematisch dargestellten Ausführungsbeispiels näher erläutert. In dieser zeigen die
Figuren 1a), 1c) sowie 1d) Beispiele unterschiedlicher Varianten eines Verbundes der Schichten von Leiterplatten bzw. von Leiterplatten-Zwischenprodukten,
Figuren 1b) sowie 1e) Varianten eines Verbundes der Schichten der Leiterplatte bzw. des Leiterplatten-Zwischenprodukts gemäß Schritt a) des erfindungsgemäßen Verfahrens,
Fig. 2 eine Darstellung von Schritt b) des erfindungsgemäßen Verfahrens,
Fig. 3 eine Darstellung von Schritt c) des erfindungsgemäßen Verfahrens,
Fig. 4 eine Darstellung von Schritt d) des erfindungsgemäßen Verfahrens,
Fig. 5 eine Darstellung von Schritt e) des erfindungsgemäßen Verfahrens,
Fig. 6 eine Darstellung von Schritt f) des erfindungsgemäßen Verfahrens,
Fig. 7 eine Darstellung von Schritt g) des erfindungsgemäßen Verfahrens,
Fig. 8 eine mögliche Art der Weiterverarbeitung der mit dem erfindungsgemäßen Verfahren hergestellten Leiterplatte bzw. des Leiterplatten-Zwischenprodukts mit einer Ankontaktierung der eingebetteten Komponenten in der Ebene der Kontaktpads der eingebetteten Komponenten,
Fig. 9 eine mögliche Art der Weiterverarbeitung der mit dem erfindungsgemäßen Verfahren hergestellten Leiterplatte bzw. des Leiterplatten-Zwischenprodukts mit einer Ankontaktierung in einer über der Ebene der Kontaktpads der eingebetteten Komponenten liegenden Kontaktschicht,
Fig. 10 eine Darstellung entsprechend Schritt e) des erfindungsgemäßen Verfahrens, wobei Komponenten unterschiedlicher Dicke in den Freistellungen positioniert wurden,
Fig. 11 die Weiterverarbeitung des Zwischenprodukts gemäß Fig. 10 im Sinne der Schritte f) und g) des erfindungsgemäßen Verfahrens,
Fig. 12 eine mögliche Art der Ankontaktierung der gemäß der Fig. 10 und 11 eingebetteten Komponenten,
Fig. 13 eine Darstellung einer Variante bei der unterschiedlich dicke Komponenten mit der Kontaktseite in Richtung der ersten temporären Trägerschicht in den Freistellungen positioniert werden,
Fig. 14 eine Darstellung des Ergebnisses der erfindungsgemäßen Weiterverarbeitung des halbfertigen Produkts gemäß Fig. 13,
Fig. 15 eine Variante einer mit dem erfindungsgemäßen Verfahren hergestellten Leiterplatte bzw. eines Leiterplatten-Zwischenprodukts und die
Fig. 16-19 eine Variante der vorliegenden Erfindung unter Verwendung eines IMS-Bauteils als einzubettende Komponente.

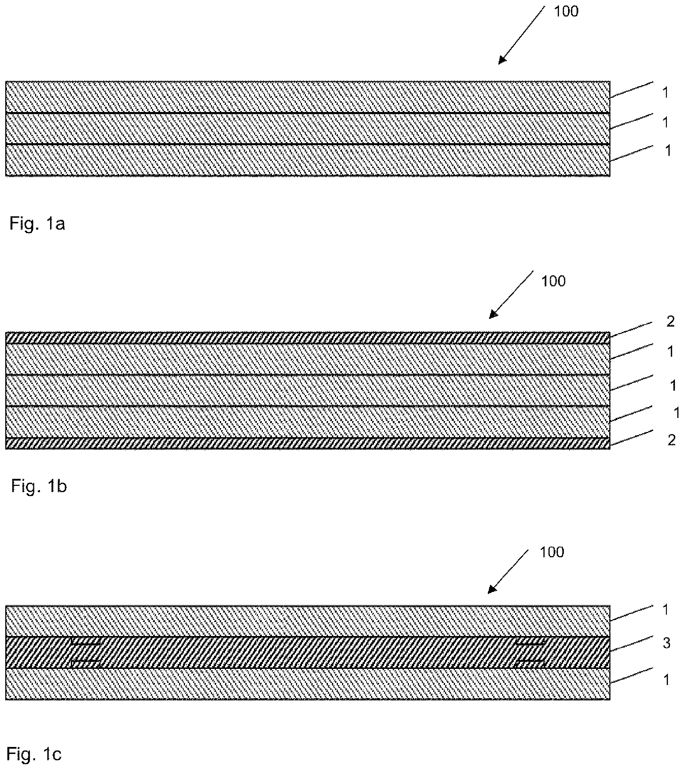

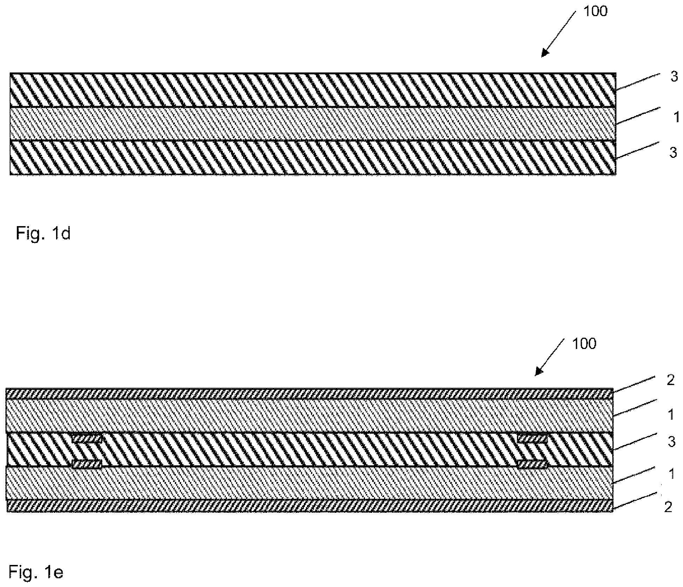

Die Figuren 1b) sowie 1e) zeigen Varianten des Verbundes der Schichten der Leiterplatte bzw. des Leiterplatten-Zwischenprodukts, wie sie im Rahmen der vorliegenden Erfindung gemäß Schritt a) bereitgestellt werden können. Die weiteren Figuren 1a), 1c) und 1d) zeigen Beispiele von unterschiedlichen Schichtverbunden. Fig. 1a) zeigt hierbei einen Verbund 100, der nur aus Lagen aus einem Prepreg-Material l(Prepreg-Lagen) besteht. Fig. 1b) zeigt einen Verbund 100 gemäß der Erfindung, der aus Prepreg-Lagen 1 und beidseitig außenliegenden Kupferschichten 2 besteht. Fig. 1c) zeigt einen Verbund 100, der aus außenliegenden Prepreg-Lagen 1 und einen zentral gelegenen Core 3 besteht, Fig. 1d) zeigt einen Verbund 100, der aus beidseitig außenliegenden Cores 3 und einer innenliegenden Prepreg-Lage 1 besteht. Fig. 1e) zeigt einen Verbund 100 gemäß der Erfindung, der aus einem innenliegendem Core 3 einer Mehrzahl von Lagen aus Prepreg-Material 1 und beidseitig außenliegenden Kupferschichten 2 besteht.

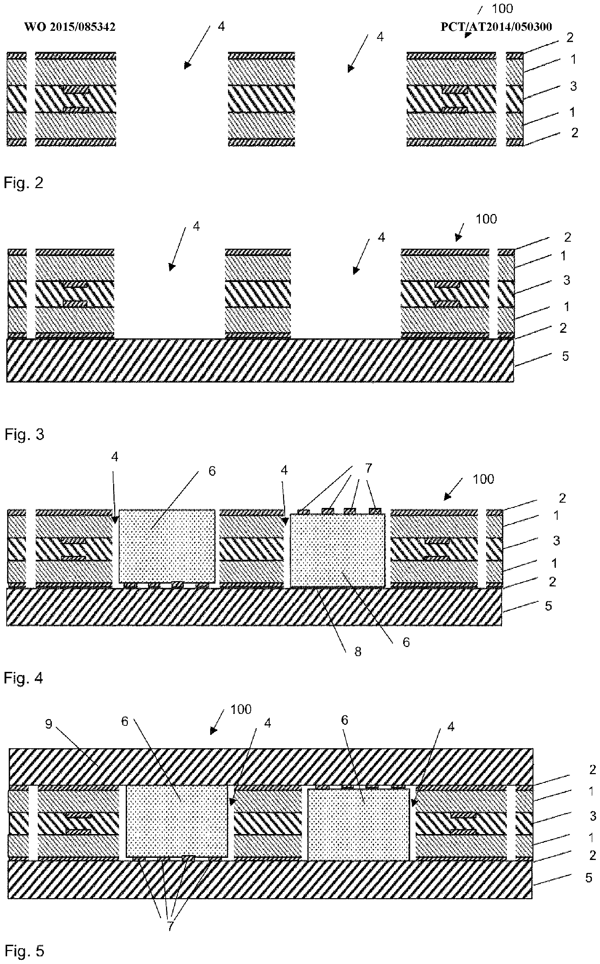

In Fig. 2 ist beispielhaft ein Verbund 100, wie in Fig. 1e), dargestellt gemäß Schritt b) mit Freistellungen 4 zur Aufnahme der einzubettenden Komponenten versehen worden. Nach dem Herstellen der Freistellungen 4 werden gemäß Schritt c) die Freistellungen 4 in dem Verbund 100 mit einer ersten temporären Trägerschicht 5, beispielsweise in Form eines Klebebands auf einer ersten Seite des Verbundes 100 abgedeckt (Fig. 3). Gemäß Schritt d) und wie in Fig. 4 dargestellt, werden in einem nächsten Verfahrensschritt die einzubettenden Komponenten 6 in die Freistellungen 4 bestückt bzw. in diesen positioniert. Wie in Fig. 4 erkennbar ist, können die Komponenten sowohl "face down" als auch "face up" positioniert werden, wobei sie im ersten Fall mit ihrer Kontaktseite bzw. ihren Kontaktpads 7 und im zweiten Fall mit ihrer Rückseite 8 an der ersten temporären Trägerschicht, die auf dieser ersten Seite des Verbundes in Form eines Klebebandes vorliegt, anhaften.

Zur Durchführung des erfindungsgemäßen Verfahrens ist es prinzipiell lediglich notwendig, zumindest den Bereich der Freistellung bzw. die Bereiche der Freistellungen mit einer ersten temporären Trägerschicht 5 abzudecken. In der industriellen Fertigung ist es jedoch zumeist einfacher, nicht nur den Bereich bzw. die Bereiche der Freistellungen mit einer ersten temporären Trägerschicht abzudecken, sondern die gesamte Fläche des Verbundes 100 mit einer kontinuierlichen ersten temporären Trägerschicht 5 zu bekleben.

In Fig. 5 ist nun zu erkennen, dass gemäß Schritt e) die Bereiche der Freistellungen auf der zweiten Seite des Verbundes 100 mit einer zweiten temporären Trägerschicht 9 abgedeckt werden, wobei es auch hier zumeist ökonomischer ist, nicht nur den Bereich der Freistellung bzw. die Bereiche der Freistellungen abzudecken, sondern eine kontinuierliche zweite temporäre Trägerschicht 9 über die gesamte Fläche des Verbundes 100 aufzubringen.

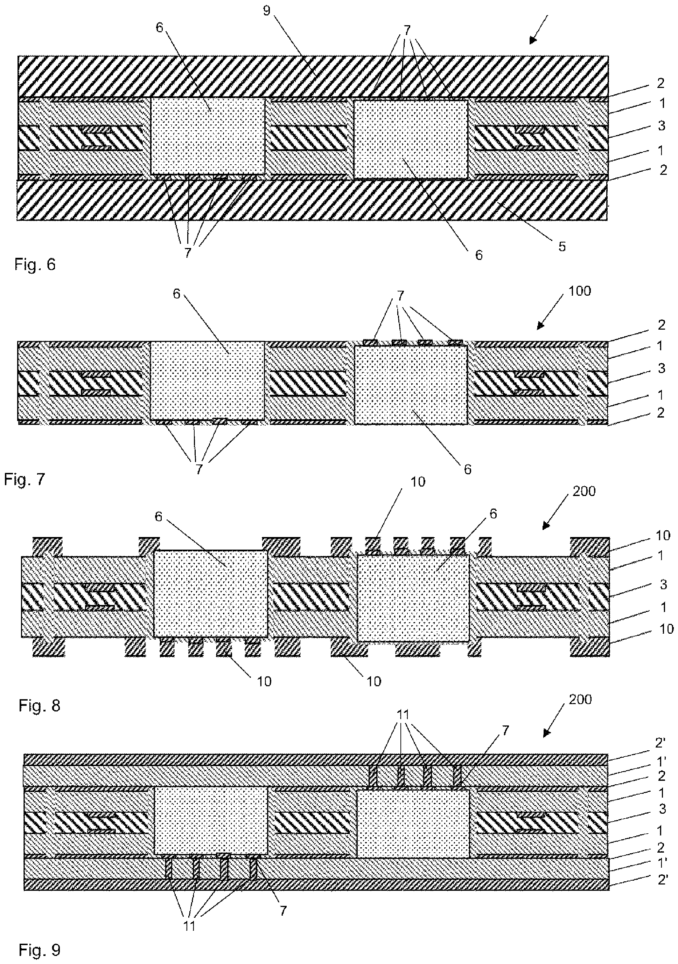

In Fig. 6 ist Schritt f) des erfindungsgemäßen Verfahrens, nämlich das Verpressen des Verbundes mit der Komponente bzw. den Komponenten unter Aushärtung des aushärtbaren Prepreg-Materials 1 dargestellt. Wie in Fig. 6 zu erkennen ist, werden die Hohlräume der Freistellungen 4 vom Harz der Lagen aus Prepreg-Material 1 ausgefüllt, sodass beim Aushärten eine zuverlässige Festlegung der Komponenten 6 im Verbund 100 erfolgt. Dadurch dass die ersten temporären Trägerschichten 5 und 9 den Verbund 100 zuverlässig räumlich begrenzen, liegen bei der in den bisherigen Figuren dargestellten Variante der Bestückung des Verbundes 100 mit Komponenten 6 die Kontaktpads 7 der Komponenten 6 nach den Entfernen der temporären Trägerschichten 5 und 9 (Fig. 7) frei und können, wie dies in Fig. 8 dargestellt ist, unmittelbar zur Ankontaktierung und dem Aufbau von hier nicht näher dargestellten Leiterzügen 10 in derselben Ebene a bzw. a' der Leiterplatte bzw. des Leiterplatten-Zwischenprodukts 200 unterzogen werden. Gemäß der in Fig. 9 gezeigten Variante kann jedoch auch ein weiterer Aufbau des Leiterplatten-Zwischenprodukts 200 erfolgen, in dem weitere Lagen aus Prepreg-Material 1' und Kontaktschichten bzw. Kupferschichten 2' nach bekannten Verfahren aufgebracht werden, wobei in diesem Fall die Ankontaktierung der Kontaktpads 7 der Komponenten 6 über sogenannten Mikrovias 11 erfolgt.

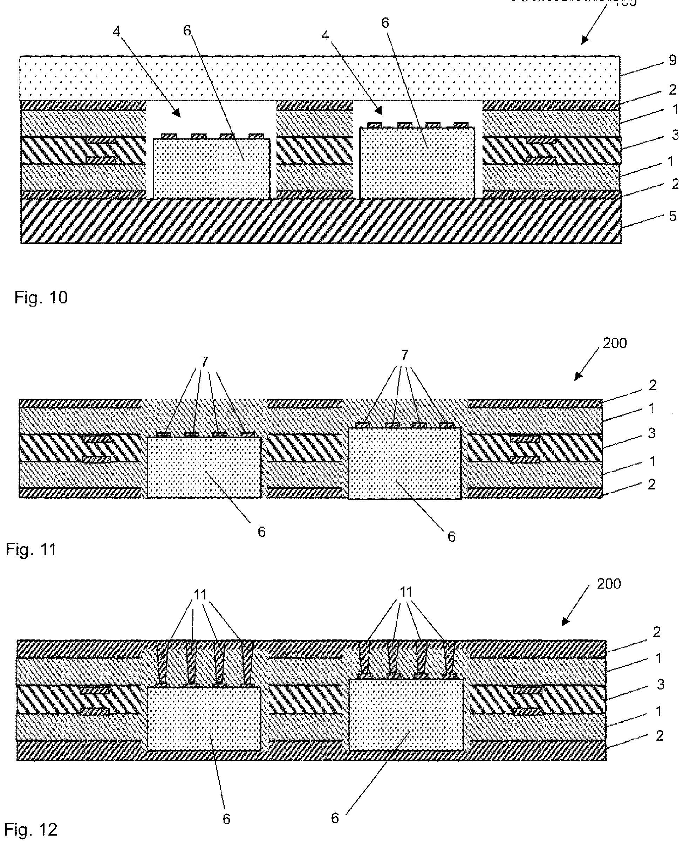

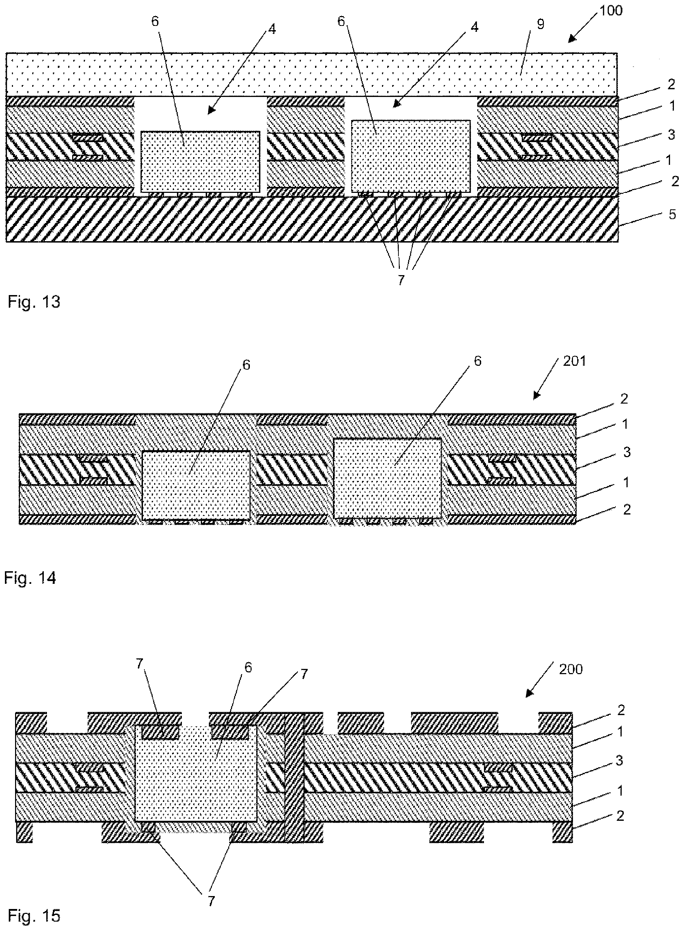

In Fig. 10 ist zu erkennen, dass Komponenten 6 unterschiedlicher Dicke in die Freistellungen 4 bestückt bzw. in diesen positioniert werden können, wobei in diesem Fall aufgrund des Umstandes, dass zwischen den Komponenten 6 und der zweiten temporären Trägerschicht ein Abstand besteht und die Komponenten 6 beim Verpressen nicht von der ersten temporären Trägerschicht 5 abgehoben werden dürfen, die zweite temporäre Trägerschicht 9 in diesem Fall kein Klebeband ist. Nach dem Verpressen gemäß Schritt f) des erfindungsgemäßen Verfahrens wird eine Leiterplatte bzw. ein Leiterplatten-Zwischenprodukt 200 erhalten, wie sie in Fig. 11 dargestellt ist, wobei eine Ankontaktierung der Komponenten 6 wiederum über Mikrovias 11 erfolgt (Fig. 12). Beim Bestücken unterschiedlich dicker Komponenten 6 in die Freistellungen 4 mit den Kontaktpads in Richtung der ersten temporären Trägerschicht 5, die in Form eines Klebebands vorliegt, muss die zweite temporäre Trägerschicht einen nicht haftende Oberfläche aufweisen, die zum Verbund 100 der Schichten der Leiterplatte bzw. des Leiterplatten-Zwischenprodukts ausgerichtet ist (fig. 13). Nach dem Verpressen gemäß Schritt f) des erfindungsgemäßen Verfahrens wird ein Leiterplatten-Zwischenprodukt 201 (Fig. 14) erhalten, welches wiederum gemäß Fig. 8 ankontaktiert werden kann.

Fig. 15 zeigt eine Variante der vorliegenden Erfindung, bei der eine Komponente 6 mit Kontakten 7 auf zwei gegenüberliegenden Seiten eingebettet wurde, wodurch ein vertikaler Stromfluss von einer Seite auf die andere Seite der Leiterplatte 200 ermöglicht wird.

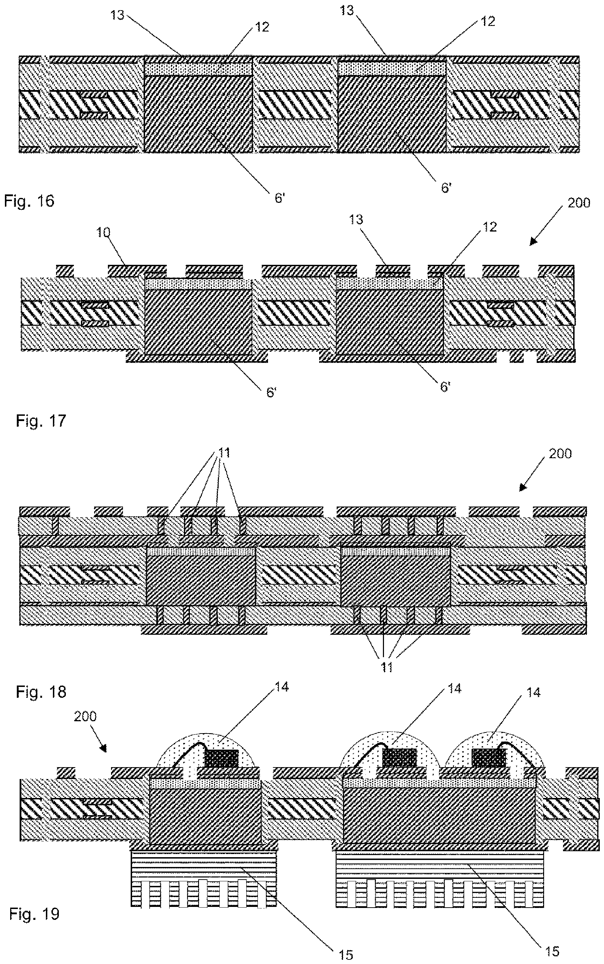

In Fig. 16 sind gemäß einer bevorzugten Ausführungsform der vorliegenden Erfindung die Komponenten 6 von IMS-Bauteilen 6' gebildet, wobei die Isolatorschicht des IMS-Bauteils 6' mit 12 und die leitende Schicht mit 13 bezeichnet ist. Das IMS-Bauteil 6' kann in herkömmlicher Weise ankontaktiert werden, wobei auch eine Ankontaktierung über Mikrovias 11 möglich ist (Fig. 18).

Besonders geeignet ist die Verwendung von IMS-Bauteilen zur Ableitung von Wärme, in dem in Figur 19 gezeigten Fall von Wärme, die von LED-Einheiten 14 in das Leiterplatten-Zwischenprodukt 200 eingebracht wird. In Figur 19 sind Kühlkörper 15 gezeigt, die die über die IMS-Bauteile 6' abgeleitete Wärme zusätzlich dissipieren.

## Patentansprüche

1. Verfahren zum Einbetten einer Komponente in eine Leiterplatte bzw. ein Leiterplatten-Zwischenprodukt, wobei die Leiterplatte bzw. das Leiterplatten-Zwischenprodukt zumindest eine isolierende Schicht aus einem Prepreg-Material aufweist und die Komponente durch das Harz des Prepreg-Materials festgelegt wird, mit einer Abfolge der folgenden Schritte:
a) Bereitstellen eines Verbundes (100) der Schichten der Leiterplatte bzw. des Leiterplatten-Zwischenprodukts (200), wobei der Verbund (100) der Schichten der Leiterplatte bzw. des Leiterplatten-Zwischenprodukts (200) aus einer Mehrzahl von Lagen aus einem aushärtbaren Prepreg-Material (1) und beidseitig außenliegenden Kupferschichten (2) besteht,
b) Herstellen einer Freistellung (4) in dem Verbund (100) zur Aufnahme der einzubettenden Komponente (6),
c) Abdecken zumindest des Bereichs der Freistellung (4) mit einer ersten temporären Trägerschicht (5) auf einer ersten Seite des Verbundes,
d) Positionieren der einzubettenden Komponente (6) in der Freistellung (4) mittels der ersten temporären Trägerschicht (5),
e) Abdecken zumindest des Bereichs der Freistellung (4) auf der zweiten Seite des Verbundes (100) mit einer zweiten temporären Trägerschicht (9),
f) Verpressen des Verbundes (100) mit der Komponente (6) unter Aushärtung des aushärtbaren Prepreg-Materials,
g) Entfernen der temporären Trägerschichten (5, 9).

2. Verfahren nach Anspruch 1, **dadurch gekennzeichnet, dass** der Verbund (100) aus einer Mehrzahl von Lagen aus einem aushärtbaren Prepreg-Material (1) und einem zentral gelegenen Core (3) sowie beidseitig außenliegenden Kupferschichten (2) besteht.

3. Verfahren nach einem der Ansprüche 1 oder 2, **dadurch gekennzeichnet, dass** der Verbund (100) der Schichten der Leiterplatte bzw. des Leiterplatten-Zwischenprodukts (200) im Wesentlichen die Dicke der einzubettenden Komponente (6) aufweist.

4. Verfahren nach einem der Ansprüche 1 bis 3, **dadurch gekennzeichnet, dass** in die Leiterplatte bzw. das Leiterplattenzwischenprodukt (200) eine Mehrzahl von Komponenten (6) eingebettet wird.

5. Verfahren nach Anspruch 4, **dadurch gekennzeichnet, dass** Komponenten (6) unterschiedlicher Dicke in die jeweiligen Freistellungen (4) bestückt werden und die zweite temporäre Trägerschicht (9) mit einer nicht-haftenden Oberfläche zum Verbund (100) der Schichten der Leiterplatte bzw. des Leiterplatten-Zwischenprodukts (200) ausgerichtet wird.

6. Verfahren nach einem der Ansprüche 1 bis 5, **dadurch gekennzeichnet, dass** die erste Seite des Verbundes (100) eine Kontaktseite der Leiterplatte bzw. des Leiterplatten-Zwischenprodukts (200) ist und die einzubettende Komponente (6) face-up zu dieser Kontaktseite in der Freistellung (4) befestigt wird.

7. Verfahren nach einem der Ansprüche 1 bis 6, **dadurch gekennzeichnet, dass** sowohl die erste Seite als auch die zweite Seite des Verbundes (100) eine Kontaktseite der Leiterplatte bzw. des Leiterplatten-Zwischenprodukts (200) ist.

8. Verfahren nach Anspruch 7, **dadurch gekennzeichnet, dass** eine Komponente (6) mit Kontakten (7) auf zwei gegenüberliegenden Seiten der Komponente (6) eingebettet wird.

9. Verfahren nach einem der Ansprüche 1 bis 8, **dadurch gekennzeichnet, dass** die Komponente (6) aus der Gruppe bestehend aus einem integrierten Schaltkreis, einer LED, einem Kühlkörper und einer Leiterplatte, insbesondere einer mehrlagigen Leiterplatte ausgewählt ist.

10. Verfahren nach einem der Ansprüche 1 bis 9, **dadurch gekennzeichnet, dass** die Komponente (6) ein Insulated Metal Substrate (IMS) Bauteil (6') ist.

11. Verfahren nach einem der Ansprüche 1 bis 10, **dadurch gekennzeichnet, dass** die erste temporäre Trägerschicht (5) in Form eines Klebebandes ausgebildet ist.

## Claims

1. Method for embedding a component into a printed circuit board or a printed circuit board intermediate product, wherein the printed circuit board or printed circuit board intermediate product has at least one insulating layer of a prepreg material and the component is fixed by the resin of the prepreg material, the method having a sequence of the following steps:
a) providing a composite (100) of the layers of the printed circuit board or printed circuit board intermediate product (200), wherein the composite (100) of the layers of the printed circuit board or printed circuit board intermediate product (200) consists of a plurality of layers of a curable prepreg material (1) and external copper layers (2) on both sides,
b) producing a clearance (4) in the composite (100) for receiving the component (6) to be embedded;
c) covering at least the region of the clearance (4) with a first temporary carrier layer (5) on a first side of the composite,
d) positioning the component (6) to be embedded in the clearance (4) by means of the first temporary carrier layer (5),
e) covering at least the region of the clearance (4) on the second side of the composite (100) with a second temporary carrier layer (9),
f) compressing the composite (100) with the component (6) while curing the curable prepreg material,
g) removing the temporary carrier layers (5, 9).

2. Method according to Claim 1, **characterized in that** the composite (100) consists of a plurality of layers made of a curable prepreg material (1) and a centrally located core (3), and external copper layers (2) on both sides.

3. Method according to either of Claims 1 or 2, **characterized in that** the composite (100) of the layers of the printed circuit board or printed circuit board intermediate product (200) essentially has the thickness of the component (6) to be embedded.

4. Method according to any one of Claims 1 to 3, **characterized in that** a plurality of components (6) are embedded in the printed circuit board or the printed circuit board intermediate product (200) .

5. Method according to Claim 4, **characterized in that** components (6) of different thicknesses are mounted in the respective clearances (4) and the second temporary carrier layer (9) is aligned with a non-adherent surface to the composite (100) of the layers of the printed circuit board or the printed circuit board intermediate product (200).

6. Method according to any one of Claims 1 to 5, **characterized in that** the first side of the composite (100) is a contact side of the printed circuit board or printed circuit board intermediate product (200) and the component to be embedded (6) is fixed in the clearance (4) face-up with respect to this contact side.

7. Method according to any one of Claims 1 to 6, **characterized in that** both the first side and the second side of the composite (100) is a contact side of the printed circuit board or the printed circuit board intermediate product (200).

8. Method according to Claim 7, **characterized in that** a component (6) having contacts (7) on two opposite sides of the component (6) is embedded.

9. Method according to any one of Claims 1 to 8, **characterized in that** the component (6) is selected from the group consisting of an integrated circuit, an LED, a heat sink and a printed circuit board, in particular a multilayer printed circuit board.

10. Method according to any one of Claims 1 to 9, **characterized in that** the component (6) is an insulated metal substrate (IMS) component (6').

11. Method according to any one of Claims 1 to 10, **characterized in that** the first temporary carrier layer (5) is designed in the form of an adhesive tape.

## Revendications

1. Procédé pour incorporer un composant dans une carte de circuit imprimé ou un produit intermédiaire de carte de circuit imprimé, dans lequel la carte de circuit imprimé ou le produit intermédiaire de carte de circuit imprimé présente au moins une couche isolante constituée d'un matériau préimprégné et les composants sont fixés à travers la résine du matériau préimprégné, comportant une succession des étapes suivantes :
a) fournir un composite (100) des couches de la carte de circuit imprimé ou du produit intermédiaire de carte de circuit imprimé (200), dans lequel le composite (100) des couches de la carte de circuit imprimé ou du produit intermédiaire de la carte de circuit imprimé (200) est constitué d'une pluralité de couches constituées d'un matériau préimprégné durcissable (1) et de couches de cuivre extérieures (2) des deux côtés,
b) produire un jeu (4) dans le composite (100) pour recevoir le composant (6) à encastrer,
c) recouvrir au moins la zone du jeu (4) avec une première couche de support temporaire (5) sur une première face du composite,
d) positionner le composant (6) à encastrer dans le jeu (4) au moyen de la première couche de support temporaire (5),
e) recouvrir au moins la zone du jeu (4) sur le deuxième côté du composite (100) avec une deuxième couche de support temporaire (9),
f) presser le composite (100) avec le composant (6) avec durcissement du matériau préimprégné durcissable,
g) retirer les couches de support temporaires (5, 9).

2. Procédé selon la revendication 1, **caractérisé en ce que** le composite (100) est constitué d'une pluralité de couches de matériau préimprégné durcissables (1) et d'un noyau central (3) ainsi que de couches de cuivre extérieures (2) des deux côtés.

3. Procédé selon une quelconque des revendications 1 ou 2, **caractérisé en ce que** le composite (100) des couches du circuit imprimé ou du produit intermédiaire de circuit imprimé (200) présente essentiellement l'épaisseur du composant (6) à encastrer.

4. Procédé selon une quelconque des revendications 1 à 3, **caractérisé en ce qu'**une pluralité de composants (6) est incorporée dans le circuit imprimé ou le produit intermédiaire de circuit imprimé (200).

5. Procédé selon la revendication 4, **caractérisé en ce que** des composants (6) d'épaisseurs différentes sont insérés dans les jeux respectifs (4) et la deuxième couche de support temporaire (9) est alignée avec une surface non adhésive pour le composite (100) des couches du circuit imprimé ou le produit intermédiaire de circuit imprimé (200).

6. Procédé selon une quelconque des revendications 1 à 5, **caractérisé en ce que** la première face du composite (100) est une face de contact de la carte de circuit imprimé ou du produit intermédiaire de la carte de circuit imprimé (200) et le composant à encastrer (6) face vers le haut à cette face de contact est fixé dans le jeu (4).

7. Procédé selon une quelconque des revendications 1 à 6, **caractérisé en ce que** tant la première face que la seconde face du composite (100) sont une face de contact de la carte de circuit imprimé ou du produit intermédiaire de la carte de circuit imprimé (200).

8. Procédé selon la revendication 7, **caractérisé en ce qu'**un composant (6) à contacts (7) est incorporé sur deux côtés opposés du composant (6).

9. Procédé selon une quelconque des revendications 1 à 8, **caractérisé en ce que** le composant (6) est choisi dans le groupe constitué par un circuit intégré, une LED, un dissipateur thermique et un circuit imprimé, notamment un circuit imprimé multicouche.

10. Procédé selon une quelconque des revendications 1 à 9, **caractérisé en ce que** le composant (6) est un composant à substrat métallique isolé (IMS) (6').

11. Procédé selon une quelconque des revendications 1 à 10, **caractérisé en ce que** la première couche de support temporaire (5) se présente sous la forme d'un ruban adhésif.
